# EUROPÄISCHE PATENTSCHRIFT

(11) **EP 1 906 212 B1**
(45) Veröffentlichungstag und Bekanntmachung des Hinweises auf die Patenterteilung: **13.01.2010**
(21) Anmeldenummer: 07017011.3
(22) Anmeldetag: 30.08.2007
(51) Int. Cl.: G02B 1/10

(54) **Optisches Element und optoelektronisches Bauelement mit solch einem optischen Element**
Optical element and opto-electronic element with such an optical element
Elément optique et composant optoélectronique doté d'un tel élément optique

(30) Priorität: 27.09.2006 DE 102006045704
(43) Veröffentlichungstag der Anmeldung: 02.04.2008
(73) Patentinhaber: OSRAM Opto Semiconductors GmbH, 93055 Regensburg (DE)
(72) Erfinder: Kräuter, Gertrud, 93051 Regensburg (DE)
(74) Vertreter: Epping - Hermann - Fischer

(56) Entgegenhaltungen:
- EP-A- 1 542 041
- DE-A1-102005 018 336

## Beschreibung

Es wird ein optisches Element angegeben. Darüber hinaus wird ein optoelektronisches Bauelement mit solch einem optischen Element angegeben.

Die Druckschrift DE 102005018336 beschreibt ein optoelektronisches Bauelement mit einem optischen Element.

Die Druckschrift EP 1 542 041 A1 beschreibt ein optisches Element aus einem Kunststoffmaterial, das mit einer Schutzschicht umhüllt ist, die das optische Element vor Feuchtigkeit schützt.

Eine zu lösende Aufgabe besteht darin, ein optisches Element anzugeben, das verbesserte Alterungseigenschaften aufweist. Eine weitere zu lösende Aufgabe besteht darin, ein optisches Element anzugeben, das besonders temperaturstabil ist. Weiter besteht eine zu lösende Aufgabe darin, ein optisches Element anzugeben, das besonders kostengünstig herstellbar ist. Eine weitere zu lösende Aufgabe besteht darin, ein optoelektronisches Bauelement mit solch einem optischen Element anzugeben.

Gemäß zumindest einer Ausführungsform des optischen Elements umfasst das optische Element einen Optikkörper. Der Optikkörper des optischen Elements bildet die funktionelle Komponente des optischen Elements. Das heißt, der Optikkörper ist der optische Funktionsträger des optischen Elements und ist beispielsweise dazu vorgesehen, durch ihn tretende oder auf ihn treffende elektromagnetische Strahlung optisch zu manipulieren. Neben dem Optikkörper kann das optische Element beispielsweise einen Halter umfassen, der den Optikkörper mechanisch stützt und an einer vorgegebenen Stelle hält.

Gemäß zumindest einer Ausführungsform des optischen Elements enthält der Optikkörper ein Kunststoffmaterial oder besteht aus einem Kunststoffmaterial. Ein Optikkörper, der ein Kunststoffmaterial enthält, ist besonders einfach und kostengünstig herstellbar. Beispielsweise kann der Optikkörper mittels eines Spritzguss- oder eines Spritzpressverfahrens hergestellt sein.

Gemäß zumindest einer Ausführungsform ist die Oberfläche des Optikkörpers zumindest stellenweise mit einer Schutzschicht versehen. Insbesondere sind Außenflächen des Optikkörpers mit der Schutzschicht versehen, die Strahlungsdurchtrittsflächen des Optikkörpers miteinander verbinden.

Bevorzugt ist der Optikkörper mit der Schutzschicht beschichtet. Vorzugsweise ist die gesamte Oberfläche des Optikkörpers mit der Schutzschicht versehen. Das heißt, der Optikkörper ist vorzugsweise vollständig von der Schutzschicht umhüllt, so dass alle freiliegenden Außenflächen des Optikkörpers von der Schutzschicht vollständig bedeckt sind. Vollständig umhüllt heißt in diesem Zusammenhang auch, dass es keine frei zugänglichen Bereiche der Oberfläche des Optikkörpers gibt, die frei von der Schutzschicht sind. Insbesondere sind dann nicht nur Strahlungsdurchtrittsflächen des Optikkörpers mit der Schutzschicht bedeckt, sondern zum Beispiel auch Flächen, die die Strahlungsdurchtrittsflächen miteinander verbinden. Es ist also möglich, dass der ganze Optikkörper von der Schutzschicht umhüllt ist, so dass eine keine Flächen des Optikkörpers gibt, die von der Schutzschicht unbedeckt sind. Bevorzugt ist die Schutzschicht dabei direkt auf den Optikkörper aufgebracht. Das heißt, die Schutzschicht ist dann beispielsweise direkt auf das Kunststoffmaterial aufgebracht, aus dem der Optikkörper besteht, ohne das weitere Materialien zwischen Optikkörper und Schutzschicht angeordnet sind.

Gemäß zumindest einer Ausführungsform des optischen Elements enthält die Schutzschicht ein Siliziumoxid. Das bedeutet, die Schutzschicht enthält ein Oxid des Siliziums. Vorzugsweise besteht die Schutzschicht aus einem Siliziumoxid.

Gemäß zumindest einer Ausführungsform des optischen Elements umfasst das optische Element einen Optikkörper, der ein Kunststoffmaterial enthält, wobei der Optikkörper vollständig von einer Schutzschicht umhüllt ist, die ein Siliziumoxid enthält. Dabei ist es möglich, dass neben dem Optikkörper auch andere Komponenten des optischen Elements - beispielsweise ein Halter für den Optikkörper - mit der Schutzschicht vollständig umhüllt sind. Im Extremfall kann das gesamte optische Element mit der Schutzschicht vollständig umhüllt ein. Die Schutzschicht ist dann bevorzugt direkt auf den Optikkörper beziehungsweise das optische Element aufgebracht.

Gemäß zumindest einer Ausführungsform des optischen Elements besteht der Optikkörper aus einem Thermoplastmaterial. Vorzugsweise kann dann das gesamte optische Element aus dem Thermoplastmaterial bestehen. Das optische Element kann dabei einstückig oder mehrstückig ausgebildet sein. Beispielsweise handelt es sich bei dem Kunststoff, aus dem der Optikkörper gebildet ist oder den der Optikkörper enthält, um eines der folgenden Materialien: PMMA, PMMI, PC, COC, COP, Hochtemperatur-PC.

Gemäß zumindest einer Ausführungsform des optischen Elements besteht die Schutzschicht, mit der der Optikkörper beschichtet ist, aus Siliziumdioxid. Siliziumdioxid eignet sich aufgrund seiner guten Haftfestigkeit am Kunststoff des Optikkörpers und seiner hohen chemischen sowie physikalischen Beständigkeit besonders gut als Material für die Schutzschicht.

Gemäß zumindest einer Ausführungsform des optischen Elements weist die Schutzschicht eine Dicke auf, die geringer ist als die Wellenlänge der elektromagnetischen Strahlung, zu deren optischen Beeinflussung der Optikkörper vorgesehen ist. Ist das optische Element beispielsweise vorgesehen, in einem optoelektronischen Bauelement eingesetzt zu werden, indem das optische Element zur Strahlformung von sichtbarem Licht einer bestimmten Wellenlänge oder eines bestimmten Wellenlängenbereichs vorgesehen ist, so ist die Dicke der Schutzschicht vorzugsweise kleiner als die Wellenlänge dieses Lichts.

Die Schutzschicht weist vorzugsweise eine gleichmäßige Dicke auf. Dabei schwankt die Dicke vorzugsweise um höchstens 10% um einen Mittelwert der Dicke.

Gemäß zumindest einer Ausführungsform des optischen Elements beträgt die Dicke der Schutzschicht höchstens 400 nm. Das optische Element eignet sich dann besonders gut zur optischen Beeinflussung von sichtbarem Licht.

Gemäß zumindest einer Ausführungsform des optischen Elements ist die Schutzschicht als Diffusionsbarriere gegen das Eindringen von Feuchtigkeit in den Optikkörper vorgesehen. Das heißt, die Schutzschicht ist geeignet, das Eindringen von Feuchtigkeit in den Optikkörper zu hemmen oder gar zu verhindern.

Gemäß zumindest einer Ausführungsform des optischen Elements ist die Schutzschicht als Diffusionsbarriere gegen das Eindringen von atmosphärischen Gasen in den Optikkörper vorgesehen. Das heißt, die Schutzschicht ist geeignet, das Eindringen von atmosphärischen Gasen in den Optikkörper zu hemmen oder gar zu verhindern.

Gemäß zumindest einer Ausführungsform des optischen Elements verbessert die Schutzschicht die thermische Beständigkeit des Optikkörpers. Dies ist unter anderem dadurch erreicht, dass die Schutzschicht das Eindringen von Feuchtigkeit in den Optikkörper hemmt oder verhindert. Dadurch ist es möglich, dass der Optikkörper auch bei hohen Temperaturen von mehr als 100 Grad Celsius stabil und mechanisch fest bleibt und seine Form beibehält.

Gemäß zumindest einer Ausführungsform ist die Schutzschicht mittels eines Plasma-unterstützten Beschichtungsverfahrens wie zum Beispiel Plasma-unterstützer chemischer Dampfphasenepitaxie (PECVD) auf den Optikkörper aufgebracht. Bei einem Plasma-unterstützen Beschichtungsverfahren handelt es sich um ein besonders Material schonendes Verfahren, bei dem ein Film gleichmäßiger Dicke auf den Optikkörper bei relativ geringen Beschichtungstemperaturen aufgebracht werden kann.

Gemäß zumindest einer Ausführungsform des optischen Elements ist der Optikkörper des optischen Elements geeignet, die durch ihn tretende elektromagnetische Strahlung auf zumindest eine der folgenden Arten optisch zu beeinflussen:
Reflektieren, Brechung, Beugung, Transmission. Beim optischen Element kann es sich zum Beispiel um eine Brechungslinse, eine Beugungslinse, einen Lichtleiter oder einen optischen Konzentrator handeln.

Es wird ferner ein optoelektronisches Bauelement angegeben. Gemäß zumindest einer Ausführungsform des optoelektronischen Bauelementes umfasst das Bauelement zumindest einen optoelektronischen Halbleiterchip, der zur Strahlungserzeugung oder Strahlungsdetektion vorgesehen ist. Bei dem Halbleiterchip handelt es sich zum Beispiel um einen Lumineszenzdiodenchip wie einen Laserdiodenchip oder Leuchtdiodenchip. Ferner kann es sich bei dem optoelektronischen Halbleiterchip um einen Fotodetektorchip handeln. Darüber hinaus ist es möglich, dass es sich bei dem optoelektronischen Halbleiterchip um eine organische Leuchtdiode (OLED) handelt.

Dem optoelektronischen Halbleiterchip ist vorzugsweise zumindest ein optisches Element, wie es in Verbindung mit einer der vorherigen Ausführungsformen beschrieben ist, derart nachgeordnet, dass zumindest ein Teil der vom optoelektronischen Halbleiterchip im Betrieb erzeugten oder detektierten Strahlung durch den Optikkörper des optischen Elements tritt. Vorzugsweise wird zumindest ein Teil der durchgetretenen elektromagnetischen Strahlung dabei optisch beeinflusst.

Gemäß zumindest einer Ausführungsform des optoelektronischen Bauelements wird der Optikkörper des optischen Elements im Betrieb des optoelektronischen Bauelements zumindest stellenweise auf eine Temperatur von wenigstens 120 Grad Celsius erwärmt. Eine solche Erwärmung kann beispielsweise aufgrund der Abwärme des optoelektronischen Halbleiterchips im Betrieb des optoelektronischen Bauelements auftreten. Das optische Element ist insbesondere aufgrund der Schutzschicht geeignet, eine derartige Temperaturbelastung dauerhaft unbeschadet zu überstehen.

Im Folgenden werden das hier beschriebene optische Element sowie das hier beschriebene optoelektronische Bauelement anhand von Ausführungsbeispielen und den dazugehörigen Figuren näher erläutert.
- Figur 1: zeigt ein hier beschriebenes optisches Element in einer schematischen Perspektivdarstellung gemäß einem ersten Ausführungsbeispiel.
- Figur 2: zeigt ein hier beschriebenes optisches Element gemäß einem zweiten Ausführungsbeispiel in einer schematischen Perspektivdarstellung.
- Figur 3A: zeigt ein optisches Element gemäß einem dritten Ausführungsbeispiel in einer schematischen Perspektivdarstellung.
- Figur 3B: zeigt den Optikkörper des in der Figur 3A dargestellten optischen Element in einer schematischen Schnittdarstellung.
- Figur 4: zeigt ein hier beschriebenes optoelektronisches Bauelement gemäß einem Ausführungsbeispiel in einer schematischen Perspektivdarstellung.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

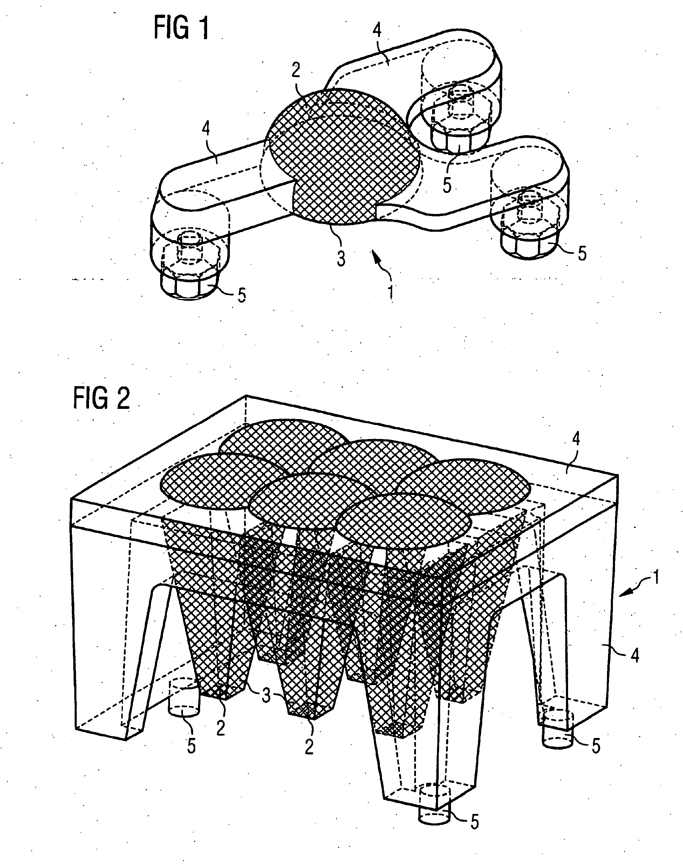

Figur 1 zeigt ein hier beschriebenes optisches Element 1 in einer schematischen Perspektivdarstellung gemäß einem ersten Ausführungsbeispiel. Bei dem optischen Element handelt es sich um eine Brechungslinse. Das optische Element 1 umfasst einen Optikkörper 2. Der Optikkörper 2 besteht aus einem Thermoplastmaterial. Der Optikkörper 2 bildet eine Brechungslinse. An den Optikkörper 2 schließen sich Halter 4 an. Die Halter 4 bestehen aus dem gleichen Material wie der Optikkörper 2 und sind vorzugsweise einstückig mit diesem hergestellt und ausgebildet. Die Halter 4 umfassen jeweils Passstifte 5, mittels denen das optische Element - beispielsweise durch eine Pressfassung - mechanisch an einem Träger befestigt werden kann.

Zumindest der Optikkörper 2 des optischen Elements 1 ist mit einer Schutzschicht 3 beschichtet. Die Schutzschicht 3 umhüllt den Optikkörper 2 vollständig. Die Schutzschicht 3 besteht aus Siliziumdioxid und ist zum Schutz des Optikkörpers gegen Feuchtigkeit und atmosphärische Gase vorgesehen.

Figur 2 zeigt ein hier beschriebenes optisches Element 1 gemäß einem zweiten Ausführungsbeispiel in einer schematischen Perspektivdarstellung. Das optische Element 1 umfasst eine Vielzahl von Optikkörpern 2. Die Optikkörper 2 bilden optische Konzentratoren, die nach Art von Pyramidenstümpfen ausgebildet sind. Jeder optische Konzentrator ist von einer gekrümmten Lichtaustrittsfläche abgeschlossen, die als Linse dient. Zumindest die Optikkörper 2 des optischen Elements 1 sind mit einer Schutzschicht 3 beschichtet, die aus Siliziumdioxid besteht.

Die Optikkörper 2 sind einstückig mit dem Halter 4 ausgebildet, der Passstifte 5 zur Befestigung des optischen Elements 1 auf einem Träger umfasst. Halter 4 und Optikkörper 2 sind beispielsweise mittels eines einzigen Spritzguss- oder Spritzpressverfahrens gemeinsam gefertigt.

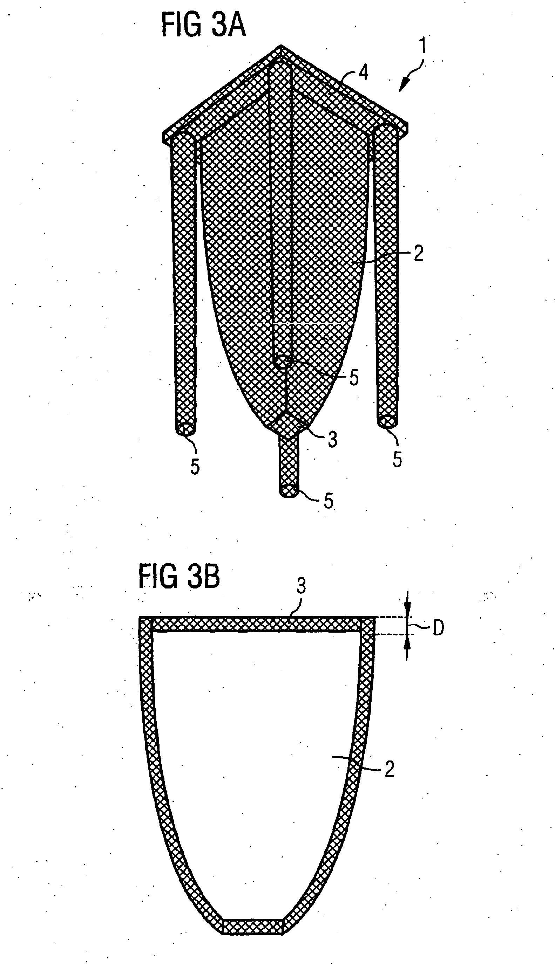

Figur 3A zeigt ein optisches Element 1 gemäß einem dritten Ausführungsbeispiel in einer schematischen Perspektivdarstellung.

Die Figur 3B zeigt den Optikkörper 2 des in der Figur 3A dargestellten optischen Element 1 in einer schematischen Schnittdarstellung.

Das optische Element 1 umfasst einen Halter 4, der Passstifte 5 aufweist, mit denen das optische Element 1 mechanisch an einem Träger befestigt werden kann. Das optische Element 1 umfasst ferner einen Optikkörper 2. Optikkörper 2 und Halter 4 können einstückig ausgebildet sein oder Optikkörper 2 und Halter 4 sind getrennt voneinander gefertigt und nachträglich zusammengeführt.

Im Ausführungsbeispiel der Figur 3 ist das gesamte optische Element, das heißt, Halter 4 und Optikkörper 2 mit der Schutzschicht 3, die aus Siliziumdioxid besteht, beschichtet.

Der Optikkörper 2 kann zumindest stellenweise auch nach Art eines der folgenden optischen Grundelemente gebildet sein: zusammengesetzter parabolischer Konzentrator (CPC - Compound Parabolic Concentrator), zusammengesetzter elliptischer Konzentrator (CEC - Compound Elliptic Concentrator), zusammengesetzter hyperbolischer Konzentrator (CHC - Compound Hyperbolic Concentrator). Die Seitenflächen des Optikkörpers sind dann zumindest stellenweise nach Art eines dieser optischen Grundelemente gebildet. Ferner ist es möglich, dass der Optikkörper zumindest stellenweise nach Art eines Kegelstumpfs oder eines Pyramidenstumpfs geformt ist, der sich zur Lichtquelle hin verjüngt.

Wie der Schnittdarstellung der Figur 3B zu entnehmen ist, weist die Schutzschicht 3 eine gleichmäßige Dicke D auf, die höchstens 400 nm beträgt. Bevorzugt beträgt die Dicke D dabei wenigsten 20 nm. Auf diese Weise ist sichergestellt, dass die Schutzschicht ihre Schutzfunktion wahrnehmen kann.

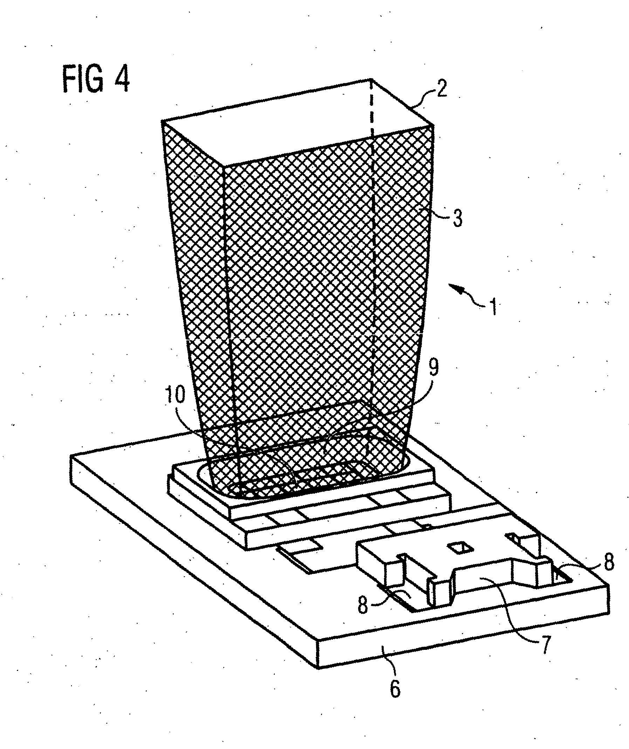

Figur 4 zeigt ein hier beschriebenes optoelektronisches Bauelement gemäß einem Ausführungsbeispiel in einer schematischen Perspektivdarstellung. Das optoelektronische Bauelement umfasst einen Anschlussträger 6. Bei dem Anschlussträger 6 handelt es sich beispielsweise um eine Metallkernplatine. Auf dem Anschlussträger 6 sind Kontaktstellen 8 ausgebildet, mittels denen das optoelektronische Bauelement von außerhalb elektrisch kontaktiert werden kann. Dazu ist eine Steckverbindung 7 vorgesehen. Weiter umfasst das optoelektronische Bauelement einen keramischen Träger 9, auf den eine Mehrzahl von Leuchtdiodenchips 10 angeordnet ist. Den Leuchtdiodenchips 10 ist in Strahlrichtung ein optisches Element 1 nachgeordnet, wie es beispielsweise in Verbindung mit einer der Figuren 1, 2, 3A, 3B beschrieben ist. Das optische Element 1 ist vollständig von einer Schutzschicht 3, die aus Siliziumdioxid besteht, umhüllt.

Durch die im Betrieb der Leuchtdiodenchips 10 erzeugte Abwärme wird das optische Element 1 zumindest stellenweise, vorzugsweise vollständig auf Temperaturen von wenigstens 120 Grad Celsius erwärmt. Aufgrund der Schutzschicht 3 ist der Optikkörper 2 derart temperaturstabil, dass trotz der Erwärmung kein Erweichen und/oder Verformen des Optikkörpers 2 eintritt, wie dies ohne Schutzschicht 3 der Fall wäre.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

Diese Patentanmeldung beansprucht die Priorität der deutschen Patentanmeldung 102006045704.8, deren Offenbarungsgehalt hiermit durch Rückbezug aufgenommen wird.

## Patentansprüche

1. Optisches Element (1) mit
- einem Optikkörper (2), der ein Kunststoffmaterial enthält, und
- einem Halter (4) für den Optikkörper, der aus dem gleichen Material wie der Optikkörper (2) besteht,
wobei der Optikkörper (2) und der Halter (4) vollständig von einer Schutzschicht (3) umhüllt sind, die ein Siliziumoxid enthält.

2. Optisches Element (1) nach dem vorherigen Anspruche bei dem die Schutzschicht (3) direkt auf den Optikkörper (2) aufgebracht ist, ohne dass sich weitere Materialien zwischen Optikkörper (2) und Schutzschicht (3) befinden.

3. Optisches Element nach zumindest einem der vorherigen Ansprüche,
bei der der Optikkörper (2) aus einem Thermoplastmaterial besteht.

4. Optisches Element nach zumindest einem der vorherigen Ansprüche,
bei dem die Schutzschicht (3) aus Siliziumdioxid besteht.

5. Optisches Element nach zumindest einem der vorherigen Ansprüche,
bei dem die Schutzschicht (3) eine Dicke (D) aufweist, die geringer ist, als die Wellenlänge der elektromagnetischen Strahlung zu deren optischen Beeinflussung der Optikkörper (2) vorgesehen ist.

6. Optisches Element nach zumindest einem der vorherigen Ansprüche,
bei dem die Schutzschicht (3) eine Dicke (D) aufweist, die höchstens 400 nm beträgt.

7. Optisches Element nach zumindest einem der vorherigen Ansprüche,
bei dem die Schutzschicht (3) als Diffusionsbarriere gegen das Eindringen von Feuchtigkeit in den Optikkörper (2) vorgesehen ist.

8. Optisches Element nach zumindest einem der vorherigen Ansprüche,
bei dem die Schutzschicht (3) als Diffusionsbarriere gegen das Eindringen von atmosphärische Gasen in den Optikkörper (2) vorgesehen ist.

9. Optisches Element nach zumindest einem der vorherigen Ansprüche,
bei dem die Schutzschicht (3) die thermische Beständigkeit des Optikkörpers (2) erhöht.

10. Optisches Element nach zumindest einem der vorherigen Ansprüche,
bei dem die Schutzschicht (3) mit einem Plasma-unterstützten Beschichtungsverfahren auf den Optikkörper (2) aufgebracht ist.

11. Optisches Element nach zumindest einem der vorherigen Ansprüche,
bei dem der Optikkörper (2) die durch ihn tretende elektromagnetische Strahlung auf zumindest eine der folgenden Arten optisch beeinflusst: Reflektion, Brechung, Beugung, Transmission.

12. Optoelektronisches Bauelement mit
- zumindest einem optoelektronischen Halbleiterchip(10), der zur Strahlungserzeugung oder Strahlungsdetektion vorgesehen ist und
- einem optischen Element (1) nach zumindest einem der vorherigen Ansprüche, wobei
das optische Element (1) dem zumindest einen optoelektronischen Halbleiterchip (10) derart nachgeordnet ist, dass zumindest ein Teil der vom optoelektronischen Halbleiterchip (10) im Betrieb erzeugten oder detektierten elektromagnetischen Strahlung durch den Optikkörper (2) des optischen Elements (1) tritt.

13. Optoelektronisches Bauelement nach dem vorherigen Anspruch,
bei dem der Optikkörper (2) im Betrieb des Bauelements auf eine Temperatur von wenigstens 120° Celsius erwärmt wird.

## Claims

1. Optical element (1) comprising
- an optical body (2) containing a plastic material, and
- a holder (4) for the optical body, the holder comprising the same material as the optical body (2),
wherein the optical body (2) and the holder (4) are completely encapsulated by a protective layer (3) containing a silicon oxide.

2. Optical element (1) according to the preceding claim, in which the protective layer (3) is applied directly to the optical body (2) without further materials being situated between optical body (2) and protective layer (3).

3. Optical element according to at least one of the preceding claims,
in which the optical body (2) comprises a thermoplastic material.

4. Optical element according to at least one of the preceding claims,
in which the protective layer (3) comprises silicon dioxide.

5. Optical element according to at least one of the preceding claims,
in which the protective layer (3) has a thickness (D) which is less than the wavelength of the electromagnetic radiation for whose optical influencing the optical body (2) is provided.

6. Optical element according to at least one of the preceding claims,
in which the protective layer (3) has a thickness (D) which is at most 400 nm.

7. Optical element according to at least one of the preceding claims,
in which the protective layer (3) is provided as a diffusion barrier against the penetration of moisture into the optical body (2).

8. Optical element according to at least one of the preceding claims,
in which the protective layer (3) is provided as a
diffusion barrier against the penetration of atmospheric gases into the optical body (2).

9. Optical element according to at least one of the preceding claims,
in which the protective layer (3) increases the thermal stability of the optical body (2).

10. Optical element according to at least one of the preceding claims,
in which the protective layer (3) is applied to the optical body (2) by means of a plasma enhanced coating method.

11. Optical element according to at least one of the preceding claims,
in which the optical body (2) optically influences the electromagnetic radiation passing through it in at least one of the following ways: reflection, refraction, diffraction, transmission.

12. Optoelectronic component comprising
- at least one optoelectronic semiconductor chip (10) provided for generating radiation or detecting radiation, and
- an optical element (1) according to at least one of the preceding claims, wherein
the optical element (1) is disposed downstream of the at least one optoelectronic semiconductor chip (10) in such a way that at least part of the electromagnetic radiation generated or detected by the optoelectronic semiconductor chip (10) during operation passes through the optical body (2) of the optical element (1).

13. Optoelectronic component according to the preceding claim,
in which the optical body (2) is heated to a temperature of at least 120° Celsius during the operation of the component.

## Revendications

1. Elément optique (1) qui présenté :
- un corps optique (2) qui contient un matériau synthétique et
- un support (4) pour le corps optique, constitué du même matériau que le corps optique (2),
le corps optique (2) et le support (4) étant entièrement englobés dans une couche de protection (3) qui contient un oxyde de silicium.

2. Elément optique (1) selon la revendication précédente, dans lequel la couche de protection (3) est appliquée directement sur le corps optique (2) sans que d'autres matériaux soient placés entre le corps optique (2) et la couche de protection (3).

3. Elément optique selon au moins l'une des revendications précédentes, dans lequel le corps optique (2) est constitué d'un matériau thermoplastique.

4. Elément optique selon au moins l'une des revendications précédentes, dans lequel la couche de protection (3) est constituée de dioxyde de silicium.

5. Elément optique selon au moins l'une des revendications précédentes, dans lequel l'épaisseur (D) de la couche de protection (3) est inférieure à la longueur d'onde du rayonnement électromagnétique que le corps optique (2) doit influencer optiquement.

6. Elément optique selon au moins l'une des revendications précédentes, dans lequel la couche de protection (3) a une épaisseur (D) d'au plus 400 nm.

7. Elément optique selon au moins l'une des revendications précédentes, dans lequel la couche de protection (3) est prévue comme barrière à la diffusion qui empêche la pénétration d'humidité dans le corps optique (2).

8. Elément optique selon au moins l'une des revendications précédentes, dans lequel la couche de protection (3) est prévue comme barrière à la diffusion qui empêche la pénétration de gaz atmosphériques dans le corps optique (2).

9. Elément optique selon au moins l'une des revendications précédentes, dans lequel la couche de protection (3) améliore la tenue du corps optique (2) à la chaleur.

10. Elément optique selon au moins l'une des revendications précédentes, dans lequel la couche de protection (3) est appliquée sur le corps optique (2) à l'aide d'un procédé de revêtement soutenu par plasma.

11. Elément optique selon au moins l'une des revendications précédentes, dans lequel le corps optique (2) agit optiquement d'au moins l'une des manières suivantes : réflexion, réfraction, diffraction, transmission, sur le rayonnement électromagnétique qui le traverse.

12. Composant optoélectronique qui présenté :
- au moins une puce semi-conductrice optoélectronique (10) qui est prévue pour produire un rayonnement ou détecter un rayonnement et
- un élément optique (1) selon au moins l'une des revendications précédentes,
- l'élément optique (1) étant placé en aval de la ou des puces semi-conductrices optoélectroniques (10) de telle sorte qu'au moins une partie du rayonnement électromagnétique produit ou détecté en fonctionnement par la puce semi-conductrice optoélectronique (10) traverse le corps optique (2) de l'élément optique (1).

13. Composant optoélectronique selon la revendication précédente, dans lequel le corps optique (2) est chauffé à une température d'au moins 120° Celsius lorsque le composant fonctionne.
